# EUROPEAN PATENT APPLICATION

(11) **EP 4 135 150 A1**
(43) Date of publication of application: **15.02.2023**
(21) Application number: 21845810.7
(22) Date of filing: 20.07.2021
(51) Int. Cl.: H02J 7/00, G01R 31/382, G01R 19/165

(54) **SYSTEM AND METHOD FOR CONTROLLING CHARGING/DISCHARGING BETWEEN BATTERIES OF DUAL BATTERY**

(30) Priority: 22.07.2020 KR 20200090886
(71) Applicant: LG Energy Solution, Ltd., Seoul 07335 (KR)
(72) Inventor: KWON, Jae Kuk, Daejeon 34122 (KR); LEE, Jin Hyun, Daejeon 34122 (KR)
(74) Representative: Plasseraud IP
(86) International application number: PCT/KR2021/009338
(87) International publication number: WO 2022/019612

(57) **Abstract**

The present invention relates to a system and method for controlling charging/discharging between batteries of a dual battery. The system for controlling charging/discharging between batteries of a dual battery according to the present invention is characterized by comprising: first and second batteries that are fastened to an external system by being connected in parallel to each other in a state in which the batteries each perform discharging to the external system, but charging/discharging between the batteries is not performed; the external system which uses the first and second batteries as driving power sources, and controls charging/discharging operations between the first and second batteries according to the voltage difference between the first and second batteries; and main charging/discharging paths through which charging/discharging currents flow between the first and second batteries and the external system and between the first and second batteries. The main charging/discharging paths comprise: first and second paths that are connected in parallel to each other and respectively formed in the first and second batteries; and a third path having one end connected to the first and second paths connected in parallel, and the other end connected to the external system.

## Description

### TECHNICAL FIELD

The present invention relates to a system and method for controlling charging/discharging between batteries of a dual battery, and more particularly, to a system and method for controlling a connection of a dual battery to prevent deterioration of a specific battery by controlling a current path between batteries of a dual battery.

### BACKGROUND ART

Batteries are used in various fields including portable electronic devices such as smart phones, notebook computers, and tablet PCs, as well as electric vehicles, energy storage batteries, and robots, and fields where batteries are used a lot in recent years, such as electric powered vehicles or smart grid systems, often require large capacity.

In order to increase the capacity of the battery pack, there may be a way to increase the capacity of the battery cell itself, but in this case, the effect of increasing the capacity is not large, and there is a physical limit to the size expansion of the battery, and it has disadvantages in that it is inconvenient to manage. Accordingly, a battery pack in which a plurality of battery cells are connected in series/parallel is applied and used in a dual battery system including two batteries electrically connected in parallel to each other.

In general, in order for the dual battery to be used for charging or discharging immediately when it is installed in an external electronic device, the charging FET and discharging FET of each battery are always controlled in an On state.

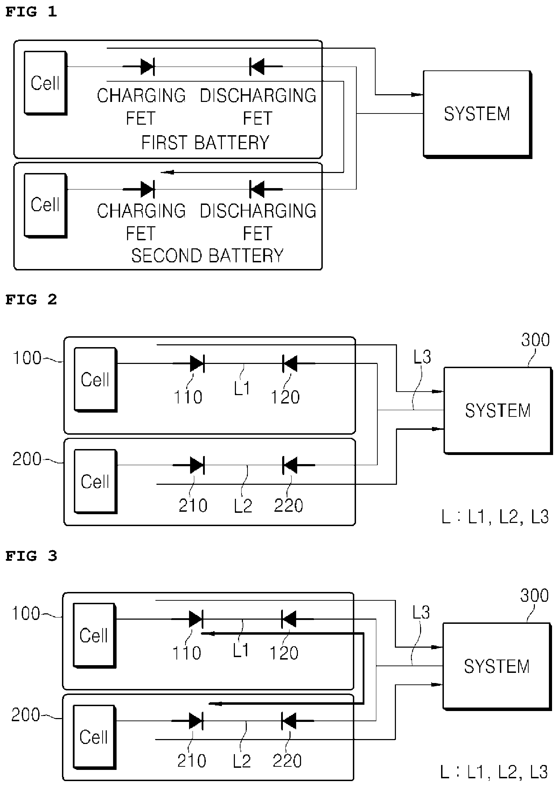

However, if a voltage difference occurs between the two batteries while the charging FET is on, in order to balance the voltage between the batteries, as shown in FIG. 1, the first battery with high voltage is simultaneously discharging to the second battery with low voltage as well as the external electronic device (external system), there is a problem in that the first battery having a high voltage is rapidly deteriorated or a protection operation is performed due to overdischarging.
(Patent Document 1) KR2019-0123582 A
(Patent Document 2) KR10-0619904 B1

### DISCLOSURE OF THE INVENTION

### TECHNICAL PROBLEM

The present invention is to solve the above problems, and to provide a charging/discharging control system and method between batteries of a dual battery that controls a charging FET of a battery according to a voltage difference between the batteries of a dual battery to prevent deterioration of a specific battery.

### TECHNICAL SOLUTION

According to the present invention, a system for controlling charging/discharging between two batteries constituting a dual battery includes: first and second batteries configured to be fastened to an external system in a state in which the first and second batteries are connected in parallel to each other and perform discharging to the external system, respectively, but not perform charging/discharging between batteries; the external system using the first and second batteries as driving power source and configured to control a charging/discharging operation between the first and second batteries according to a voltage difference between the first and second batteries; and a main charging/discharging path through which a charging/discharging current flows between the first and second batteries and the external system and between the first and second batteries, wherein the main charging/discharging path includes: first and second paths formed in the first and second batteries respectively and connected in parallel to each other; and a third path having one end connected to the first and second paths connected in parallel and the other end connected to the external system.

In detail, each of the first and second batteries includes: one or more battery cells; charging FETs respectively provided on the first and second paths to control charging of the battery; a discharging FET connected in series to the charging FETs provided on the first and second paths, respectively, to control discharging of the battery; a first communication unit configured to connect communication with the external system; a voltage measurement unit configured to measure a voltage of the corresponding battery at a predetermined interval; and a first control unit configured to receive voltage information from the communication-connected external system, and configured to switch a charging FET to an on state or maintain an off state according to control from the external system, wherein the discharging FET of each of the first and second batteries are in an on state, and the charging FET is in an off state and connected to the external system.

The first control unit includes: a voltage value transmission unit configured to transmit the voltage value of a corresponding battery measured by the voltage measurement unit to the external system through the first communication unit; a control signal reception unit configured to receive a control signal for controlling the charging FET from the external system through the first communication unit; and a FET control unit configured to switch a corresponding charging FET to an on state or maintain an off state according to a control signal from the external system received by the control signal reception unit.

Moreover, the external system includes: a system driving unit that is woken up by discharging currents from the first and second batteries to be fastened to drive the system; a second communication unit configured to connect communication with the first communication unit of each of the first and second batteries; a voltage state determination unit configured to check a voltage state of each of the first and second batteries through the second communication unit and determine whether a voltage difference between the two batteries is within a predetermined reference range; a second FET control unit configured to output a control signal for controlling the charging FETs of the first and second batteries to an on or off state according to a determination result of the voltage state determination unit; and a notification unit configured to provide notification information to a user when the voltage difference between the first and second batteries is out of the predetermined reference range according to a result of the determination of the voltage state determination unit.

Specifically, the voltage state determination unit includes: a voltage value reception unit configured to receive voltage values of the first and second batteries transmitted from the first and second batteries through the second communication unit; a voltage difference calculation unit configured to calculate a voltage difference between the first and second batteries by using the respective voltage values of the first and second batteries received by the voltage value reception unit; and a comparison unit configured to compare whether the voltage difference between the first and second batteries calculated by the voltage difference calculation unit is within a predetermined reference range, wherein the comparison unit, if the voltage difference between the first and second batteries is within a predetermined reference range, outputs a satisfaction signal indicating this, and if the voltage difference between the first and second batteries is out of the predetermined reference range, outputs a non-satisfaction signal indicating this.

Furthermore, the second FET control unit, when the satisfaction signal is output from the comparison unit, outputs an on control signal for switching the charging FETs of the first and second batteries, which are currently in an Off state, to an on state, respectively, to the first and second batteries, and when the non-satisfaction signal is output from the comparison unit, outputs an off control signal to each of the first and second batteries for maintaining the charging FETs of the first and second batteries, which are currently in an Off state, in the same state.

According to the present invention, a method for controlling charging/discharging between batteries constituting a dual battery includes: a fastening step of performing mounting of first and second batteries connected in parallel to each other to an external system while discharging to the external system, but not performing charging/discharging; a voltage measurement step of measuring a voltage of the corresponding battery in each of the first and second batteries at a predetermined period interval; a communication connection step of connecting mutual communication between the first and second batteries and the external system; a voltage value reception step of receiving a measured voltage value from each of the first and second batteries through the communication connection in the external system; a charging FET state switching determination step of controlling charging/discharging between the first and second batteries based on the measured voltage values of the first and second batteries received in the voltage value reception step; and a charging FET control step of switching the charging FET to an on state or maintaining an off state according to a determination result of the charging FET state switching determination step from the external system in each of the first and second batteries.

Specifically, the charging FET state switching determination step includes: a voltage difference calculation step of calculating a voltage difference between the first and second batteries by using the respective voltage values of the first and second batteries received in the voltage value reception step; a voltage difference comparison step of comparing whether the voltage difference values between the first and second batteries calculated in the voltage difference calculation step are within a predetermined reference range; and a control signal output step of outputting a control signal for switching the charging FETs of the first and second batteries to an on state or maintaining an off state to the first and second batteries, respectively, according to a comparison result in the voltage difference comparison step.

Here, the control signal output step includes, if the voltage difference between the first and second batteries is within a predetermined reference range according to a result of the comparison of the voltage difference comparison step, outputs an on control signal for switching the charging FETs of each of the first and second batteries, which are currently in an Off state, to an On state, and if the voltage difference between the first and second batteries is out of a predetermined reference range, outputs an off control signal for maintaining the charging FETs of the first and second batteries, which are currently in an Off state, as it is.

Accordingly, the charging FET control step, when the on control signal from the external system is output, switches the charging FETs of each of the first and second batteries, which are currently in an Off state, to an On state, and when the off control signal is output from the external system, maintains the charging FET of each of the first and second batteries, which are currently in an Off state, as it is.

### ADVANTAGEOUS EFFECTS

The present invention controls charging/discharging between batteries by controlling the charging FET of the battery according to the voltage difference between the two batteries constituting the dual battery so that it may improve battery efficiency by preventing a situation in which a specific battery deteriorates due to charging/discharging between batteries in a state with a high voltage difference.

### BRIEF DESCRIPTION OF THE DRAWINGS

FIG. 1 is a diagram illustrating a current flow formed when a conventional dual battery is coupled to an external system.
FIG. 2 is a view showing a current flow formed in an initial state in which a dual battery and an external system are fastened according to the present invention.
FIG. 3 is a diagram illustrating a current flow formed by controlling a charging FET according to a voltage difference between batteries of a dual battery in the state of FIG. 2.

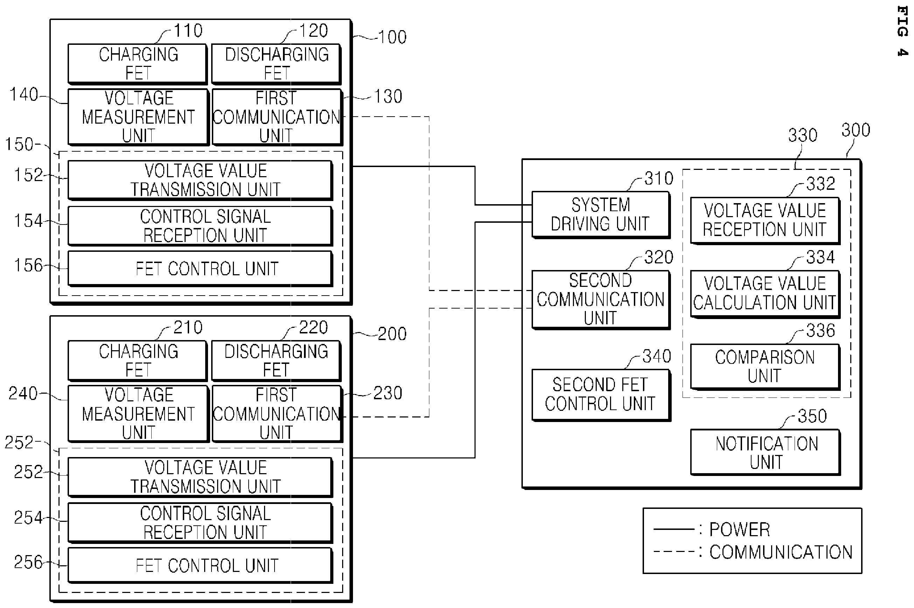

FIG. 4 is a block diagram schematically showing each configuration of a dual battery and an external system according to the present invention.
FIG. 5 is a flowchart schematically illustrating a method for controlling charging/discharging between batteries of a dual battery according to the present invention.

### MODE FOR CARRYING OUT THE INVENTION

Hereinafter, embodiments of the present invention will be described in detail with reference to the accompanying drawings so that those of ordinary skill in the art may easily implement the present invention. However, the present invention may be implemented in various forms and is not limited to the embodiments described herein. In the drawings, parts irrelevant to the description are omitted in order to clearly describe the present invention, and like reference numerals refer to like elements throughout the specification.

Hereinafter, the present invention will be described in detail with reference to the drawings.

### 1. Battery-To-Battery Charging/Discharging Control System For Dual Batteries According To Present Invention

The battery-to-battery charging/discharging control system of the dual battery according to the present invention may include the following configuration.

### 1.1. Main Charging/Discharging Path L

The main charging/discharging path is a current path formed between the first and second batteries 100 and 200 constituting the dual battery and the external system 300 using the first and second batteries 100 and 200 as driving power s ource and is composed including the following detailed path.

### A. First Path L1

The first path refers to a path formed in the first battery 100 of the main charging/discharging path L, and as shown in FIG. 2, has a structure connected to the second path L2 formed in the second battery 200, in which one end is connected to a cell included in the first battery 100 and the other end is connected in parallel with the first battery 100.

### B. Second Path L2

The second path refers to a path formed in the second battery 200 of the main charging/discharging path L, and as shown in FIG. 2, has a structure connected to the first path L1 formed in the first battery 100, in which one end is connected to a cell included in the second battery 200 and the other end is connected in parallel with the second battery 200.

### C. Third Path L3

The third path is a path formed between the first and second batteries 100 and 200 and the external system 300, and has a structure in which one end is connected to the first and second paths L1 and L2 connected in parallel, and the other end is connected to the external system 300.

Through the main charging/discharging path L composed of such first, second and third paths L1 to L3, a charging/discharging current may flow between the first and second batteries 100 and 200 and the external system 300.

### 1.2. First And Second Batteries 100 and 200

The first and second batteries connected in parallel to form a dual battery may each include the following configuration.

### A. Charging FETs 110 and 210

The charging FET is provided on the first path L1 and the second path L2, respectively, and is configured to control the flow of charging current from a battery other than itself or an external system. When described with reference to the first battery, the first battery controls the charging current flow from the second battery or external system to the cell included in the first battery 100, and when described with reference to the second battery, the second battery controls the charging current flow from the first battery or an external system to a cell included in the second battery 100.

### B. Discharging FETs 120 and 220

The discharging FET is connected in series to the charging FETs 110 and 210 respectively provided on the first path L1 and the second path L2, such that a discharging current flow from a cell included in the first battery 100 and a cell included in the second battery 200 to the external system 300 may be controlled.

Here, the above-described charging FETs 110 and 210 and discharging FETs 120 and 220 provided in each of the first and second batteries are coupled to the external system 300 in different on/off states. Specifically, all of the charging FETs 110 and 210 are in an off state, and the discharging FETs 120 and 220 are all in an on state and are coupled to the external system 300.

Therefore, in the initial state in which the first and second batteries 100 and 200 are coupled with the external system 300, as indicated by the arrow in FIG. 2, it is a state in which there is only current movement from the first path L1 to the third path L3 and from the second path L2 to the third path L3, and it is a state in which there is no current movement from the first path L1 to the second path L2 and from the second path L2 to the first path L1, that is, the first and second paths L1 and L2 are not electrically connected in parallel to each other.

Accordingly, in the initial state of the first and second batteries 100 and 200 coupled with the external system 300, each discharging operation to the external system 300 is performed, but charging/discharging operation between batteries is not performed.

### C. First Communication Units 130 and 230

The first communication unit is a configuration for connecting communication with the external system 300 fastened to the first and second batteries 100 and 200, and through this, battery voltage information and FET control information may be exchanged between the first and second batteries 100 and 200 and the external system 300.

### D. Voltage Measurement Units 140 and 240

The voltage measurement unit may measure the voltage of the corresponding battery at regular intervals using a conventional method.

### E. First Control Units 150 and 250

The first control unit is configured to transmit the battery voltage information measured to the external system 300 to be fastened, and is configured to switch the charging FETs 110 and 210, which are currently in an off state, to an on state or maintain them in an off state according to the control from the external system 300, and may be configured including the following detailed configuration.

### 1) Voltage Value Transmission Units 152 and 252

The voltage value transmission unit is configured to transmit the voltage values of the first and second batteries 100 and 200 measured by the voltage measurement units 140 and 240 to the external system 300 through the first communication units 130 and 230.

### 2) Control Signal Reception Units 154 and 254

The control signal reception unit is configured to receive a control signal for controlling the charging FET from the external system 300 through the first communication units 130 and 230.

### 3) FET Control Units 156 and 256

The FET control unit may switch the charging FETs 110 and 220 to an on state or maintain an off state according to the control signal from the external system 300 received by the control signal reception units 154 and 254.

When the control signal received from the external system 300 in the control signal reception units 154 and 254 is an on control signal, the FET control unit may switch the charging FETs 110 and 210, which are currently in an Off state, to an On state.

On the other hand, when the control signal received from the external system 300 in the control signal reception units 154 and 254 is an off control signal, the FET control unit may maintain the charging FETs 110 and 210, which are currently in an off state, as it is, that is, in an off state.

### 1.3. External System 300

The external system is a configuration that uses the first and second batteries 100 and 200 as driving power source, and may include, for example, a smart phone or a tablet PC. Such an external system is driven by a discharging current discharging a mounted dual battery, so that the following components included in the system may operate.

### A. System Driving Unit 310

When the first and second batteries 100 and 200 and the external system 300 are fastened, the system driving unit is woken up by a discharging current that is introduced through the first path L1 -> the third path L3 and the second path L2 -> the third path L3 from each of the first and second batteries 100 and 200, so that the following configurations may be driven.

### B. Second Communication Unit 320

The second communication unit is a configuration for connecting communication with the first communication units 130 and 230 of the first and second batteries 100 and 200, and through this, may check the voltage state of the first and second batteries 100 and 200 and transmit a control signal for controlling the charging FETs 110 and 210.

### C. Voltage State Determination Unit 330

The voltage state determination unit may check the voltage state of the first and second batteries 100 and 200 through the second communication unit 320 to determine whether a voltage difference between the two batteries is within a predetermined reference range.

### 1) Voltage Value Reception Unit 332

The voltage value reception unit may receive the voltage values of the first and second batteries transmitted from the first and second batteries 100 and 200 through the second communication unit 320.

### 2) Voltage Difference Calculation Unit 334

The voltage difference calculation unit may calculate a voltage difference between the first and second batteries 100 and 200 using respective voltage values of the first and second batteries received from the voltage value reception unit 332.

### 3) Comparison Unit 336

The comparison unit may compare whether the voltage difference between the first and second batteries 100 and 200 calculated by the Voltage Difference Calculation Unit 334 is within a predetermined reference range.

As a result of the comparison, if the voltage difference of the first and second batteries 100 and 200 is within a predetermined reference range, a satisfaction signal indicating this may be output.

On the other hand, when the voltage difference of the first and second batteries 100 and 200 is out of a predetermined reference range, a non-satisfaction signal indicating this may be output.

### D. Second FET Control Unit 340

The second FET control unit may output a control signal for controlling the charging FETs 110 and 210 of the first and second batteries 100 and 200 to an on or off state according to the comparison result in the comparison unit 336 of the voltage state determination unit 330.

When a satisfaction signal is output from the comparison unit 336, that is, if the voltage difference between the first battery 100 and the second battery 200 is within a predetermined reference range, in order for normal charging/discharging to be made between the first and second batteries 100 and 200, an on control signal for switching the charging FETs 110 and 210 of the first and second batteries 100 and 200, which are currently in an off state, to an on state may be output. In this case, each of the first and second batteries 100 and 200 receiving the on control signal switches their charging FETs 110 and 210 into an On state and thus, a current flow path as shown in FIG. 3 is formed, so that a charging/discharging operation between batteries may be performed.

On the other hand, when a non-satisfaction signal is output from the comparison unit 336, that is, if the voltage difference between the first battery 100 and the second battery 200 is out of the predetermined reference range, in order to prevent a situation in which a specific battery charges the other battery due to the voltage difference between the two batteries, that is, charging/discharging is performed between the batteries, an off control signal for maintaining the charging FETs 110 and 210 of the first and second batteries 100 and 200, which are currently in an Off state, as it is may be output. In this case, each of the first and second batteries 100 and 200 receiving the off control signal maintains their charging FETs 110 and 210 in the off state and thus, a current flow path as shown in FIG. 2 is maintained, so that the charging/discharging operation between the batteries is not performed.

Accordingly, when the voltage difference between the batteries of the dual battery is in an appropriate state, since charging/discharging between the batteries proceeds, it is possible to prevent the problem of a specific battery being discharging to another battery and an external system at the same time, which leads to rapid deterioration, so that it is possible to improve the efficiency of the dual battery.

### E. Notification Unit 350

The system of the present invention may further include a notification unit for notifying the user of a state in which the voltage difference between the batteries of the first and second batteries 100 and 200 is out of a predetermined reference range. Through this, when a non-satisfaction signal is output from the comparison unit 336 of the voltage state determination unit 330, by displaying notification information indicating the state of the voltage difference between the batteries on the display of the external system, the user may be able to recognize that this is a situation in which charging/discharging between the batteries is not controlled due to the voltage difference between the batteries.

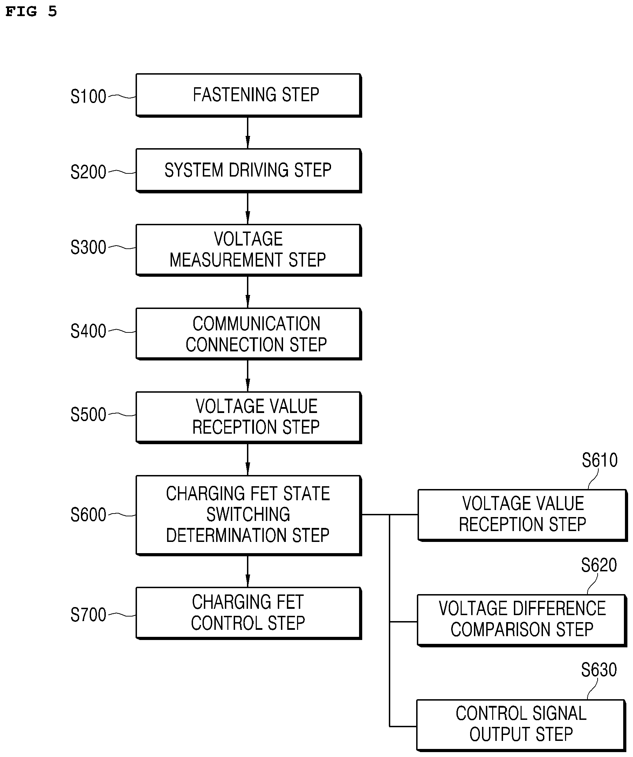

2. Method For Controlling Charging/Discharging Between Batteries Of Dual Battery According To Present Invention (See FIG. 5)

The method for controlling inter-battery charging/discharging of a dual battery according to the present invention may include the following steps.

### 2.1. Fastening Step S100

The fastening step is a step of fastening the dual batteries consisting of the first and second batteries 100 and 200 to the external system 300, and when fastened, a main charging/discharging path L, which is a current path, is formed between the first and second batteries 100 and 200 and the external system 300. Here, when the first and second batteries 100 and 200 are installed in the external system 300 for the first time, the discharging FETs 120 and 220 are in an On state, but the charging FETs 110 and 210 are mounted in the external system 300 in an Off state, and as shown in FIG. 2, in the first and second batteries 100 and 200, current movement is not performed between the batteries but only current movement to the external system 300 is performed.

That is, when the first and second batteries 100 and 200 are first installed in the external system 300, current moves only in the direction of L1 -> L3 and L2 -> L3, so that each of the first and second batteries 100 and 200 is in a state of discharging to only the external system 300 .

### 2.2 System Driving Step S200

The system driving step is a step in which the external system 300 is driven by the discharging current from the first and second batteries 100 and 200 engaged in the fastening step S100.

The external system 300 is woken up by the discharging current from the first and second batteries 100 and 200 supplied through the paths of L1 -> L3 and L2 -> L3, and is driven by using it as a driving power source.

### 2.3. Voltage Measurement Step S300

The voltage measurement step is a step of measuring the voltage of each of the first and second batteries at regular intervals, and is performed by the voltage measurement units 140 and 240 configured in each of the first and second batteries described above.

### 2.4. Communication Connection Step S400

The communication connection step is a step of connecting communication between the first and second batteries 100 and 200 and the external system 300. Intercommunication connection may be made by the first communication unit 130 and 230 configured in each of the first and second batteries 100 and 200 and the second communication unit 320 configured in the external system 300. Through these steps, the first and second batteries 100 and 200 and the external system 300 are mutually communicatively connected, so that the steps to be described later may be performed.

### 2.5. Voltage Value Reception Step S500

The voltage value reception step is a step of receiving a measured voltage value from each of the first and second batteries 100 and 200 in the external system 300. This step includes receiving, by the voltage value reception unit 332 of the external system 300, the voltage values of the first and second batteries 100 and 200 transmitted from each of the first and second batteries 100 and 200 connected to each other through the communication connection step S400.

### 2.6. Charging FET State Switching Determination Step S600

The charging FET state switching determination step is a step of determining whether to switch the charging FETs 110 and 210 of each of the first and second batteries 100 and 200, which are currently in an Off state, to an On state, based on the voltage values of the first and second batteries 100 and 200 received through the voltage value reception step S500 in the external system 300, and may be configured including the following detailed steps.

### A. Voltage Difference Calculation Step S610

First, a voltage difference between the two batteries may be calculated using the respective voltage values of the first and second batteries 100 and 200 received in the voltage value reception step S500 (voltage difference calculation unit 334) .

### B. Voltage Difference Comparison Step S620

The voltage difference comparison step may compare whether the voltage difference value between the first and second batteries 100 and 200 calculated in the voltage difference calculation step S620 is within a predetermined reference range (comparison unit 336).

### C. Control Signal Output Step S630

The control signal output step may output a control signal for switching the charging FETs 110 and 210 of the first and second batteries 100 and 200 to an On state or maintaining an Off state according to the comparison result of the voltage difference comparison step S620.

If the voltage difference between the first and second batteries 100 and 200 is within a predetermined reference range according to the comparison result of the voltage difference comparison step S520, an on control signal for switching the charging FETs 110 and 210 of the first and second batteries 100 and 200, which are currently in an off state, to an on state may be output such that normal charging/discharging may be made between the first and second batteries 100 and 200.

On the other hand, if the voltage difference between the first and second batteries 100 and 200 is out of a predetermined reference range, in order to prevent a situation in which a specific battery charges the other battery due to the voltage difference between the two batteries, that is, charging/discharging is performed between the batteries, an off control signal for maintaining the charging FETs 110 and 210 of the first and second batteries 100 and 200, which are currently in an Off state, as it is, may be output (second FET control unit 340).

### 2.7. Charging FET Control Step S700

The charging FET Control step is a step of switching the charging FETs 110 and 210 to an on state or maintaining an off state according to the control signal from the external system 300 output through the control signal output step S630 of the charging FET state switching determination step S600 in each of the first and second batteries and this is performed by the FET control units 156 and 256 of the first and second batteries 110 and 210.

When the control signal from the external system 300 is output through the control signal output step S630, by switching the charging FETs 110 and 210 of each of the first and second batteries 100 and 200, which are currently in an Off state, to an On state, as shown in FIG. 3, normal charging/discharging may be performed between the two batteries.

On the other hand, when the off control signal is output from the external system 300 through the control signal output step S630, by maintaining the charging FETs 110 and 210 of each of the first and second batteries 100 and 200, which are currently in an Off state, as it is, As shown in FIG. 2, charging/discharging between the two batteries may be prevented from proceeding.

On the other hand, although the technical idea of the present invention has been specifically described according to the above embodiment, it should be noted that the above embodiments are for the purpose of explanation and not limitation. In addition, those skilled in the art in the technical field of the present invention will be able to understand that various embodiments are possible within the scope of the spirit of the present invention.

## Claims

1. A system for controlling charging/discharging between two batteries constituting a dual battery, the system comprising:
first and second batteries configured to be fastened to an external system in a state in which the first and second batteries are connected in parallel to each other and perform discharging to the external system, respectively, but not perform charging/discharging between batteries;
the external system using the first and second batteries as driving power source and configured to control a charging/discharging operation between the first and second batteries according to a voltage difference between the first and second batteries; and
a main charging/discharging path through which a charging/discharging current flows between the first and second batteries and the external system and between the first and second batteries,
wherein the main charging/discharging path comprises:
first and second paths formed in the first and second batteries respectively and connected in parallel to each other; and
a third path having one end connected to the first and second paths connected in parallel and the other end connected to the external system.

2. The system of claim 1, wherein each of the first and second batteries comprises:
one or more battery cells;
charging FETs respectively provided on the first and second paths to control charging of the battery;
a discharging FET connected in series to the charging FETs provided on the first and second paths, respectively, to control discharging of the battery;
a first communication unit configured to connect communication with the external system;
a voltage measurement unit configured to measure a voltage of the corresponding battery at a predetermined interval; and
a first control unit configured to receive voltage information from the communication-connected external system, and configured to switch a charging FET to an on state or maintain an off state according to control from the external system,
wherein the discharging FET of each of the first and second batteries are in an on state, and the charging FET is in an off state and connected to the external system.

3. The system of claim 2, wherein the first control unit comprises:
a voltage value transmission unit configured to transmit the voltage value of a corresponding battery measured by the voltage measurement unit to the external system through the first communication unit;
a control signal reception unit configured to receive a control signal for controlling the charging FET from the external system through the first communication unit; and
a FET control unit configured to switch a corresponding charging FET to an on state or maintain an off state according to a control signal from the external system received by the control signal reception unit.

4. The system of claim 3, wherein the external system comprises:
a system driving unit that is woken up by discharging currents from the first and second batteries to be fastened to drive the system;
a second communication unit configured to connect communication with the first communication unit of each of the first and second batteries;
a voltage state determination unit configured to check a voltage state of each of the first and second batteries through the second communication unit and determine whether a voltage difference between the two batteries is within a predetermined reference range;
a second FET control unit configured to output a control signal for controlling the charging FETs of the first and second batteries to an on or off state according to a determination result of the voltage state determination unit; and
a notification unit configured to provide notification information to a user when the voltage difference between the first and second batteries is out of the predetermined reference range according to a result of the determination of the voltage state determination unit.

5. The system of claim 4, wherein the voltage state determination unit comprises:
a voltage value reception unit configured to receive voltage values of the first and second batteries transmitted from the first and second batteries through the second communication unit;
a voltage difference calculation unit configured to calculate a voltage difference between the first and second batteries by using the respective voltage values of the first and second batteries received by the voltage value reception unit; and
a comparison unit configured to compare whether the voltage difference between the first and second batteries calculated by the voltage difference calculation unit is within a predetermined reference range,
wherein the comparison unit,
if the voltage difference between the first and second batteries is within a predetermined reference range, outputs a satisfaction signal indicating this, and
if the voltage difference between the first and second batteries is out of the predetermined reference range, outputs a non-satisfaction signal indicating this.

6. The system of claim 5, wherein the second FET control unit,
when the satisfaction signal is output from the comparison unit, outputs an on control signal for switching the charging FETs of the first and second batteries, which are currently in an Off state, to an on state, respectively, to the first and second batteries, and
when the non-satisfaction signal is output from the comparison unit, outputs an off control signal to each of the first and second batteries for maintaining the charging FETs of the first and second batteries, which are currently in an Off state, in the same state.

7. A method for controlling charging/discharging between batteries constituting a dual battery, the method comprising:
a fastening step of performing mounting of first and second batteries connected in parallel to each other to an external system while discharging to the external system, but not performing charging/discharging between the batteries;
a voltage measurement step of measuring a voltage of the corresponding battery in each of the first and second batteries at a predetermined period interval;
a communication connection step of connecting mutual communication between the first and second batteries and the external system;
a voltage value reception step of receiving a measured voltage value from each of the first and second batteries through the communication connection in the external system;
a charging FET state switching determination step of controlling charging/discharging between the first and second batteries based on the measured voltage values of the first and second batteries received in the voltage value reception step; and
a charging FET control step of switching the charging FET to an on state or maintaining an off state according to a determination result of the charging FET state switching determination step from the external system in each of the first and second batteries.

8. The method of claim 7, wherein the charging FET state switching determination step comprises:
a voltage difference calculation step of calculating a voltage difference between the first and second batteries by using the respective voltage values of the first and second batteries received in the voltage value reception step;
a voltage difference comparison step of comparing whether the voltage difference values between the first and second batteries calculated in the voltage difference calculation step are within a predetermined reference range; and
a control signal output step of outputting a control signal for switching the charging FETs of the first and second batteries to an on state or maintaining an off state to the first and second batteries, respectively, according to a comparison result in the voltage difference comparison step.

9. The method of claim 8, wherein the control signal output step comprises,
if the voltage difference between the first and second batteries is within a predetermined reference range according to a result of the comparison of the voltage difference comparison step, outputs an on control signal for switching the charging FETs of each of the first and second batteries, which are currently in an Off state, to an On state, and
if the voltage difference between the first and second batteries is out of a predetermined reference range, outputs an off control signal for maintaining the charging FETs of the first and second batteries, which are currently in an Off state, as it is.

10. The method of claim 9, wherein the charging FET control step,
when the on control signal from the external system is output, switches the charging FETs of each of the first and second batteries, which are currently in an Off state, to an On state, and
when the off control signal is output from the external system, maintains the charging FET of each of the first and second batteries, which are currently in an Off state, as it is.
